# EUROPÄISCHE PATENTSCHRIFT

(11) **EP 0 510 376 B1**
(45) Veröffentlichungstag und Bekanntmachung des Hinweises auf die Patenterteilung: **05.06.1996**
(21) Anmeldenummer: 92105257.7
(22) Anmeldetag: 27.03.1992
(51) Int. Cl.: G01R 15/20

(54) **Magnetkern für einen Stromsensor nach dem Kompensationsprinzip**
Magnetic circuit for current sensor using compensation principle
Circuit magnétique pour sonde de courant selon principe de compensation

(30) Priorität: 25.04.1991 DE 4113496
(43) Veröffentlichungstag der Anmeldung: 28.10.1992
(73) Patentinhaber: VACUUMSCHMELZE GMBH, D-63412 Hanau (DE)
(72) Erfinder: Lenhard, Friedrich, Dipl.-Ing., W-6450 Hanau 1 (DE)
(74) Vertreter: Fuchs, Franz-Josef, Dr.-Ing.

(56) Entgegenhaltungen:
- EP-A- 0 132 745
- EP-A- 0 243 630
- EP-A- 0 294 590
- DE-A- 3 705 450
- DE-A- 3 715 789
- US-A- 4 454 557

## Beschreibung

Die Erfindung betrifft einen Magnetkern für einen Stromsensor, bei dem das in einem Magnetkern von einer von dem zu messenden Strom durchflossenen Primärwicklung erzeugte Magnetfeld durch den Kompensationsstrom in einer Sekundärwicklung kompensiert wird, wobei zur Steuerung des Kompensationsstromes ein Magnetfelddetektor in der Nähe eines Luftspaltes des Magnetkerns so angeordnet ist, daß er ein von dem Magnetfeld des Magnetkerns beeinflußtes Ausgangssignal liefert, welches in einer Auswerteschaltung ausgewertet wird, deren Ausgang den Strom in der als Kompensationswicklung dienenden Sekundärwicklung im Sinne einer Verringerung des den Magnetfelddetektor beeinflussenden Magnetfeldes steuert.

Ein derartiger Magnetkern für einen Stromsensor ist im Prinzip aus EP-294590 A2 bekannt. Bei diesem Magnetkern für einen Stromsensor werden die Amplituden des in einer Indikatorwicklung fließenden Stromes getrennt für die positive und die negative Halbwelle verglichen. Je nach dem, wie der Meßkern - hier streifenförmiges Element genannt - durch den Magnetfluß im Magnetkern vormagnetisiert wird, erhält man am Ausgang einer Auswerteschaltung ein positives oder negatives Signal, das über einen Verstärker auf die Kompensationswicklung des Magnetkreises gegeben wird.

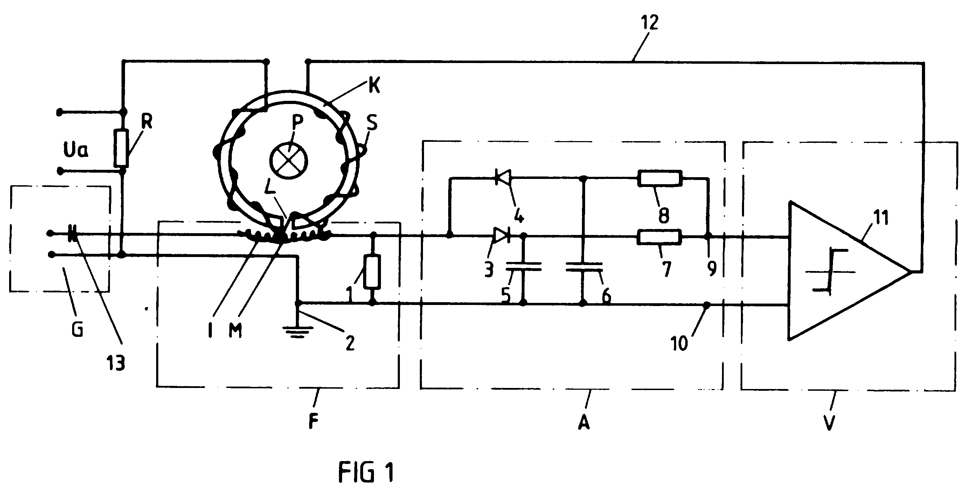

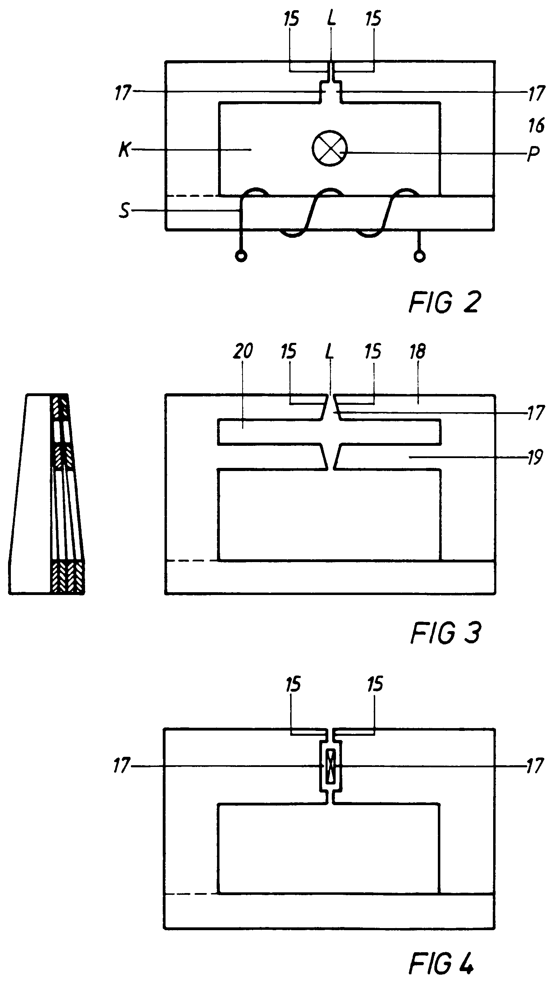

Figur 1 zeigt das Prinzipschaltbild entsprechend der bekannten Anordnung und in den Fig. 2 bis 4 sind Kernformen für den erfindungsgemäßen Magnetkern dargestellt.

In Figur 1 ist einem Wechselspannungsgenerator G ein Feldsensor F so nachgeschaltet, daß der vom Wechselspannungsgenerator G gelieferte Strom über eine Indikatorwicklung I und einen Widerstand 1 zur Erde 2 fließt. Hierdurch entsteht an den Klemmen des Widerstandes 1 eine Spannung, die dem Strom in der Indikatorwicklung I proportional ist. Die Indikatorwicklung I umschließt dabei einen Meßkern M, der außer von dem Strom in der Indikatorspule I auch von dem Magnetfluß in einem Magnetkern K beeinflußt wird.

Die an den Klemmen des Widerstands 1 entstehende Spannung wird nun einer Auswerteschaltung A zugeführt. Diese besteht aus zwei antiparallel geschalteten Dioden 3 und 4, die über Kondensatoren 5 und 6 mit Erde 2 verbunden sind. Die Dioden 3 und 4 liegen in Reihe zu Widerständen 7 und 8, die beide an eine Ausgangsklemme 9 der Auswerteschaltung angeschlossen sind. Die zweite Ausgangsklemme 10 der Auswerteschaltung ist wiederum mit Erde 2 verbunden.

Der Auswerteschaltung A ist nun eine Verstärkerschaltung V nachgeschaltet, die man auch als Regler mit Sollspannung Null zwischen den Ausgangsklemmen 9 und 10 der Auswerteschaltung bezeichnen könnte. Die Verstärkerschaltung besteht im wesentlichen aus einem Verstärker 11, der schon bei sehr kleinen Werten der Eingansspannung seine maximale Ausgangsspannung abgibt - also einen sehr hohen Verstärkungsfaktor aufweist.

Der Verstärker 11 ist über eine Leitung 12 mit der Sekundärwicklung S des Magnetkerns K verbunden. Durch die Sekundärwicklung S fließt damit der Kompensationsstrom, der ein Maß für den Strom in der Primärwicklung P des Magnetkerns K darstellt. Der zweite Anschluß der Sekundärwicklung S ist über einen Meßwiderstand R wiederum mit Erde verbunden, so daß an dem Meßwidertand R eine Spannung abfällt, die dem Strom in der Sekundärwicklung und damit auch dem Strom in der Primärwicklung P proportional ist. Diese Spannung ist hier mit Ua bezeichnet.

Im vorgestellten Schaltungsbeispiel ist innerhalb des Wechselspannungsgenerators G ein Reihenkondensator 13 vorgesehen, so daß der Wechselspannungsgenerator G sowohl in der positiven als auch in der negativen Halbwelle jeweils die gleiche Stromzeitfläche aufweist - also keinen Gleichstromanteil enthält.

Wenn die Frequenz des Wechselspannungsgenerators G gegenüber der Frequenz in der Primärwicklung P sehr hoch ist, wird sich die Vormagnetisierung des Meßkerns während mehrerer Ummagnetisierungsperioden des Meßkerns M kaum ändern. Zur Erläuterung der Wirkungsweise kann also die durch den Meßstrom in der Primärwicklung P erzeugte Vormagnetisierung des Meßkerns M als konstant angenommen werden. Diese Vormagnetisierung ergibt sich durch die Differenz der von der Primärwicklung P und der Sekundärwicklung S erzeugten Flüsse im Magnetkern K und bewirkt, daR der Meßkern M entweder während der positiven oder der negativen Halbwelle des Stromes in der Indikatorwicklung weiter in die Sättigung ummagnetisiert wird.

Es wird also - auch abhängig von der Kurvenform der vom Wechselspannungsgenerator G gelieferten Spannung - die positive und negative Halbwelle des Stromes in der Indikatorwicklung I ( = Spannungsabfall am Widerstand 1) verschieden verformt. Die Halbwellen erhalten damit unter anderem unterschiedliche Maximalwerte, deren Differenz ein Maß für die Vormagnetisierung des Meßkernes darstellt. Anstelle einer bestimmten Wechselspannung könnte der Wechselspannungsgenerator G auch einen eingeprägten Strom liefern.

Diese unterschiedlichen Spannungsamplituden der Halbwellen werden nun in der Auswerteschaltung A ausgewertet. Der Kondensator 5 wird über die Diode 3 auf eine Spannung aufgeladen, die etwa der Amplitudenspannung der positiven Halbwelle entspricht, und über die Diode 4 wird der Kondensator 6 auf eine Spannung aufgeladen, die der negativen Amplitudenspannung des Spannungsabfalls am Widerstand 1 im Feldsensor F entspricht.

Durch die Widerstände 7 und 8 wird der Mittelwert beider Spannungen an den Kondensatoren 5 und 6 gebildet, der die Ausgangsspannung der Auswerteschaltung darstellt. Diese Ausgangsspannung verändert über den Verstärker 11 in der Verstärkerschaltung V den Kompensationsstrom in der Sekundärwicklung S und damit den Spannungsabfall am Meßwiderstand R so lange, bis die Vormagnetisierung des Meßkerns M verschwindet und damit die Ausgangsspannung der Auswerteschaltung A zu Null wird.

Aus dieser Wirkungsweise ist zu sehen, daß Unsymmetrien der positiven und negativen Halbwelle ausgenutzt werden, um den Magnetisierungszustand des Magnetkerns K zu erfassen. Anstelle der Auswertung der Stromamplitude - wie in dem vorliegenden Beispiel geschildert - können auch Unterschiede in der Größe oder der Strom- bzw. Spannungszeitfläche der unterschiedlichen Halbwellen des Stromes in der Indikatorwicklung I ausgenutzt werden, wie dies beispielsweise in der Anordnung nach DE-PS 3715789 der Fall ist, oder wie es auch in der DE-OS 3705450 beschrieben wird.

In der letztgenannten Offenlegungsschrift sind stromkompensierte Stromsensoren beschrieben mit unterschiedlichen Ausbildungen der Sensorkerne. Hiernach kann der Sensor wahlweise neben dem Kern oder in einem Luftspalt oder in einem Schlitz (Teilluftspalt) angeordnet sein.

Alle diese Anordnungen bringen für die Funktionsweise des Stromsensors bestimmte Vor- aber auch Nachteile. Derartige Stromsensoren arbeiten, abhängig von der Frequenz des zu messenden Stromes, auf unterschiedliche Weise. Bei Gleichstrom oder sehr niedrig frequenten Strömen vermag es die Auswerteschaltung, den Sekundärstrom ausreichend schnell nachzuregeln, so daß das Magnetfeld immer annähernd den Wert Null besitzt. Bei sehr hohen Frequenzen des zu messenden Stromes wird jedoch die Kopplung zwischen Primär- und Sekundärwicklung einen immer größeren Einfluß erhalten, so daß am Ausgang der Sekundärstrom sich wie bei einem Stromwandler proportional zum Primärstrom einstellt.

Aufgabe der vorliegenden Erfindung ist es nun, bei einem derartigen stromkompensierten Stromwandler eine Kernform anzugeben, die sowohl bei niedrigen als auch bei hohen Frequenzen ein Optimum für die Abbildung des Primärstromes ergibt.

Dieses Optimum wird beim Stromwandlerprinzip - also bei hohen Frequenzen - dann erreicht, wenn der Magnetkern möglichst keine Scherung in der Magnetisierungskurve besitzt, also keinen oder einen möglichst kleinen Luftspalt aufweist, wobei der Luftspalt an der engsten Stellen dadurch gebildet ist, daß dort aneinanderstoßende oder sich nur gering überlappende Enden magnetischer Bleche vorgesehen sind und daß die Bleche Ausnehmungen aufweisen, so daß die Schenkel nur auf einem Teil des Querschnitts aneinanderstoßen oder sich geringfügig überlappen.

Ein derartiger Kern besitzt aber - wenn er nicht gesättigt wird - einen sehr geringen Streufluß, so daß ein in der Nähe des Kerns angeordneter Magnetfelddetektor bei niedrigen Feldstärken keine oder keine ausreichenden Meßergebnisse liefert. Aus diesem Grunde hat man einen Luftspalt vorgesehen, der von dem Magnetfelddetektor überbrückt wird, oder in dem sich der Magnetfelddetektor befindet. Hierdurch läßt sich der Kompensationsstrom sehr gut regeln, da schon kleine Feldstärken im Magnetkern einen Magnetfluß durch den Magnetfelddetektor hervorrufen. Allerdings ist ein derartiger Luftspalt dann für hohe Frequenzen, bei denen der Stromsensor im wesentlichen als Stromwandler arbeitet, ungünstig, da durch den Luftspalt der magnetische Widerstand des Magnetkreises erhöht wird.

Aus diesem Grunde hat man bei verschiedenen Ausführungsformen in DE-OS 3705450 einen Teilschlitz oder eine Querschnittsverminderung im Bereich des Magnetfelddetektors für den Magnetkern vorgesehen. Es hat sich jedoch gezeigt, daß auch hiermit noch keine optimale Funktionsweise erreichbar ist, da dann bei sehr kleinen Werten des Magnetflusses eine Sättigung auch des verminderten Querschnittes im Bereich des Teilschlitzes nicht auftritt und so keine bzw. zu geringe Magnetfelder den Magnetfelddetektor durchsetzen. Hierdurch wird wiederum, wie beim Magnetkern ohne Luftspalt, bei niedrigen Frequenzen die exakte Nachführung des Sekundärstromes eingeschränkt.

Darüberhinaus ist eine Anordnung mit Ringkern und Magnetfelddetektor in einem Teilschlitz empfindlich gegen eventuell vorhandene Fremdfelder, die das Meßergebnis leicht beeinflussen können.

Eine Verbesserung dieser Fremdfeldempfindlichkeit erreicht man, wenn man einen stromkompensierten Stromsensor entsprechend der EP-PS 132745 einsetzt. Hier sind die Magnetfelddetektoren in Öffnungen eingesetzt, die sich in der Mitte des Querschnittes des Magnetkerns befinden. Trotz der hierbei verminderten Fremdfeldempfindlichkeit bleibt aber die Ungenauigkeit bei kleinen Magnetfeldern im Magnetkern erhalten, da dann selbst die durch die Öffnung mit dem Magnetfelddetektor geschwächten Magnetquerschnitte nicht gesättigt sind und so eine geringe Abhängigkeit der Induktion im Magnetfelddetektor von der Feldstärke im Magnetkern besteht.

Eine wesentliche Verbesserung des Sensorverhaltens bei niedrigen Frequenzen ohne Inkaufnahme der schlechteren Übersetzung durch große Luftspalte bei hohen Frequenzen erzielt man durch Anwendung der im Kennzeichen des Patentanspruchs 1 angegebenen Merkmale. Vorteilhafte Weiterbildungen sind in den Unteransprüchen beschrieben.

Eine mögliche Kernform, die die Merkmale des Anspruchs 1 erfüllt, ist in Figur 2 dargestellt. Der Magnetkern (K) besteht hier aus übereinandergeschichteten Blechen, die sich im unteren Bereich 14 überlappen und deren Enden 15 im oberen Bereich 16 aneinanderstoßen und damit einen äußerst kleinen, durch die Rauhigkeiten der Blechoberflächen bedingten Luftspalt L bilden. Die Enden 15 besitzen Ausnehmungen 17, durch die in Figur 2 der durch die aneinanderstoßenden Bleche gebildete Luftspalt L zum Innenraum des Magnetkerns stark erweitert wird. Wird jetzt ein Magnetfeldetektor in der Nähe der Ausnehmungen 17 angebracht, so bewirkt der einerseits durchgehende Luftspalt L zwischen den Enden 15, daß auch bei kleinen Magnetfeldern ein Teil des Magnetflusses den Magnetfelddetektor durchdringt. Bei etwas größerem magnetischen Feld wird der Luftspalt im Bereich der Enden 15 gesättigt, so daß der Magnetfelddetektor mit einem entsprechenden höheren Anteil des Magnetflusses beaufschlagt wird. Bei hohen Frequenzen, wenn der Stromsensor im wesentlichen als Stromwandler arbeitet, wird durch den sehr kleinen Luftspalt L zwischen den aneinanderstoßenden Enden 15 keine wesentliche Beeinträchtigung des Wandlerverhaltens erfolgen.

Um die Anordnung gegenüber Fremdfeldern unempfindlicher zu machen, läßt sich gemäß Fig. 3 außerdem der obere Bereich 16 des Magnetkerns (K) in zwei parallele Teilschenkel 18 und 19 aufteilen, zwischen denen dann eine Tasche 20 entsteht, in der beispielsweise ein Tangentialmagnetfelddetektor enthalten sein kann. Wiederum sind die Enden 15 so ausgebildet, daß sie aneinander stoßen - sie können sich auch gering überlappen. Die Ausnehmungen 17 werden hier dadurch gebildet, daß die Oberfläche der Enden 15 schräg zu den Teilschenkeln 18 und 19 verlaufen, so daß ein Luftspalt L entsteht, dessen wirksame Länge sich über den Querschnitt der Teilschenkel stetig ändert. Selbstverständlich könnte auch hier eine Luftspalterweiterung ähnlich Fig. 2 vorgesehen werden.

Figur 4 zeigt nun eine abgewandelte Anordnung nach Figur 2. Hier ist der Schenkel im oberen Bereich 16 des Magnetkerns K mit Ausnehmungen 17 versehen, die sich in der Mitte der Schenkel befinden, so daß die Schenkel oberhalb und unterhalb der Ausnehmungen 17 aneinander stoßende Enden 15 aufweisen. Hier kann man vorteilhafterweise einen Hallgenerator 21 als Magnetfelddetektor einsetzen, da dieser leicht in dem erweiterten Teil des Luftspaltes Platz findet. Die Wirkungsweise entspricht weitgehend derjenigen nach Figur 3, da auch hier eine gute Abschirmwirkung erzielbar ist.

## Patentansprüche

1. Magnetkern für einen Stromsensor nach dem Kompensationsprinzip, bei dem das in einem Magnetkern (K) von einer von dem zu messenden Strom durchflossenen Primärwicklung (P) erzeugte Magnetfeld durch den Kompensationsstrom in einer Sekundärwicklung (S) kompensiert wird, wobei zur Steuerung des Kompensationsstromes ein Magnetfelddetektor (M) mit Indikatorwicklung (I) in der Nähe eines Luftspaltes des Magnetkerns (K) so angeordnet ist, daß er ein von dem Magnetfeld des Magnetkerns (K) beeinflußtes Ausgangssignal liefert, welches in einer Auswerteschaltung ausgewertet wird, deren Ausgangsleitung (12) den Strom in der als Kompensationswicklung dienenden Sekundärwicklung (S) im Sinne einer Verringerung des den Magnetfelddetektor beeinflussenden Magnetfeldes steuert, dadurch gekennzeichnet, daß der Luftspalt (L) des Magnetkerns (K) über den Querschnitt des Magnetkerns voneinander unterschiedliche Luftspaltlängen aufweist, wobei der Luftspalt an der engsten Stelle dadurch gebildet ist, daß dort aneinanderstoßende oder sich nur gering überlappende Enden (15) magnetischer Bleche vorgesehen sind und daß die Bleche Ausnehmungen (17) aufweisen, so daß die Schenkel nur auf einem Teil des Querschnitts aneinanderstoßen oder sich geringfügig überlappen.

2. Magnetkern für einen Stromsensor nach dem Kompensationsprinzip nach Anspruch 1, dadurch gekennzeichnet, daß der den Luftspalt (L) enthaltende Schenkel in zwei Teilschenkel (18, 19) aufgeteilt ist, von denen jeder Teilschenkel einen sich in der Luftspaltlänge über den Querschnitt ändernden Luftspalt (L) aufweist.

3. Magnetkern für einen Stromsensor nach dem Kompensationsprinzip nach Anspruch 2, dadurch gekennzeichnet, daß die größeren Luftspaltlängen der Luftspalte (L) der beiden Schenkel einander zugewandt sind und daß sich der Magnetfelddetektor zwischen den Teilschenkeln befindet.

4. Magnetkern für einen Stromsensor nach einem der vorhergehenden Ansprüche, dadurch gekennzeichnet, daß der Magnetkreis in den Bereichen des Magnetkerns (K) ohne Luftspalt mindestens den gleichen magnetisch wirksamen Querschnitt besitzt, wie er in dem Bereich mit Luftspalt (1) vorgesehen ist.

## Claims

1. Magnetic core for a current sensor working on the compensation principle, wherein the magnetic field produced in a magnetic core (K) by a primary winding (P) carrying the current to be measured is compensated by the compensation current in a secondary winding (S), and for control of the compensation current a magnetic field detector (M) with an indicator winding (I) is disposed in the vicinity of an air gap of the magnetic core (K) so that it supplies an output signal which is influenced by the magnetic field of the magnetic core (K) and is evaluated in an evaluation circuit whose output lead (12) controls the current in the secondary winding (S) serving as the compensation winding in order to reduce the magnetic field influencing the magnetic field detector, characterised in that the air gap (L) of the magnetic core (K) exhibits different air gap lengths over the cross-section of the magnetic core, the air gap at the narrowest point being formed in that abutting or only slightly overlapping ends (15) of magnetic plates are provided there and in that the plates exhibit recesses (17) so that the limbs only abut or overlap slightly over a part of the cross-section.

2. Magnetic core for a current sensor working on the compensation principle according to claim 1, characterised in that the limb containing the air gap (L) is divided into two part limbs (18, 19) of which each part limb exhibits an air gap (L) changing in air gap length over the cross-section.

3. Magnetic core for a current sensor working on the compensation principle according to claim 2, characterised in that the greater air gap lengths of the air gaps (L) of the two limbs face one another and in that the magnetic field detector is located between the part limbs.

4. Magnetic core for a current sensor according to one of the preceding claims, characterised in that the magnetic circuit in the areas of the magnetic core (K) without an air gap has at least the same magnetically effective cross-section as provided in the area with the air gap (1).

## Revendications

1. Circuit magnétique pour une sonde de courant selon le principe de compensation, circuit dans lequel le champ magnétique produit dans un circuit magnétique (K) à partir d'un enroulement primaire (P) parcouru par le courant à mesurer est compensé par le courant de compensation dans un enroulement secondaire (S), tandis que pour la commande du courant de compensation un détecteur de champ magnétique (M) avec un enroulement indicateur (I) est disposé au voisinage d'un entrefer du circuit magnétique (K), de façon qu'il délivre un signal de sortie influencé par le champ magnétique du circuit magnétique (K), ce signal étant exploité dans un montage d'exploitation, dont la ligne de sortie (12) commande le courant, dans l'enroulement secondaire (S) servant d'enroulement de compensation, dans le sens d'une diminution du champ magnétique influençant le détecteur de champ magnétique ,
circuit magnétique caractérisé en ce que l'entrefer (L) du circuit magnétique (K) comporte sur la section transversale du circuit magnétique des longueurs d'entrefer différentes les unes des autres, l'entrefer étant constitué à l'endroit le plus étroit en ce qu'il est prévu à cet endroit des extrémités (15) de tôles magnétiques s'aboutant les unes contre les autres ou se chevauchant légèrement, et en ce que les tôles comportent des évidements (17), de sorte que les branches ne s'aboutent les unes contre les autres ou ne se chevauchent légèrement que sur une partie de la section transversale.

2. Circuit magnétique pour une sonde de courant selon le principe de compensation, d'après la revendication 1, caractérisé en ce que la branche contenant l'entrefer (L) est partagée en deux branches partielles (18, 19), chacune d'elles comportant un entrefer (L) dont la longueur se modifie le long de la section transversale de la branche.

3. Circuit magnétique pour une sonde de courant selon le principe de compensation, d'après la revendication 2, caractérisé en ce que les plus grandes longueurs d'entrefer (L) des deux branches sont tournées les unes vers les autres et que le détecteur de champ magnétique se trouve entre les branches partielles.

4. Circuit magnétique pour une sonde de courant selon une des revendications précédentes, caractérisé en ce que le circuit magnétique, dans les zones sans entrefer du circuit magnétique (K), a au moins la même section transversale magnétiquement efficace qu'il est prévu dans la zone avec entrefer (1).
